# EUROPÄISCHE PATENTANMELDUNG

(11) **EP 0 541 033 A2**
(43) Veröffentlichungstag der Anmeldung: **12.05.1993**
(21) Anmeldenummer: 92118775.3
(22) Anmeldetag: 02.11.1992
(51) Int. Cl.: H01L 31/18

(54) **Verfahren zur Herstellung von polykristallinen Silizium-Dünnschicht-Solarzellen**

(30) Priorität: 08.11.1991 DE 4136815
(71) Anmelder: SIEMENS AKTIENGESELLSCHAFT, D-80333 München (DE); SIEMENS SOLAR GmbH, D-80807 München (DE)
(72) Erfinder: Endrös, Arthur, Dr., W-8000 München 2 (DE); Krühler, Wolfgang, Dr., W-8025 Unterhaching (DE); Einzinger, Richard, Dr., W-8019 Steinhöring (DE); Plättner, Rolf, Dr., W-8012 Riemerling (DE)
(74) Vertreter: Fuchs, Franz-Josef, Dr.-Ing.

(57) **Zusammenfassung**

Zur Herstellung kostengünstiger, hocheffizienter und besonders dünner polykristalliner Silizium-Dünnschicht-Solarzellen wird vorgeschlagen, auf amorphen Substraten eine Siliziumkeimschicht zu erzeugen, und diese selektiv zurückzuätzen, bis einheitlich 〈111〉 orientierte Keime verbleiben. Eine darüber aufgewachsene Siliziumdünnschicht ist grobkristallin, hat senkrecht zum Substrat stehende Korngrenzen und weist aufgrund der einheitlichen Orientierung eine pyramidenförmig strukturierte Oberfläche auf. Mit daraus hergestellten Solarzellen lassen sich bereits ab 10 µm Schichtdicke hohe Photoströme erzielen.

## Beschreibung

Ein breit angelegter terrestrischer Einsatz von photovoltaischen Anlagen für Leistungsanwendungen erfordert die Bereitstellung von hocheffizienten, kostengünstigen, großflächigen und langzeitstabilen Solarzellen aus umweltverträglichen Materialien. Zur Zeit gibt es noch keine Solarzelle, die diesen Anforderungen gleichzeitig genügt.

Dünnschicht-Solarzellen aus polykristallinem Silizium (poly-Si) können mit kostengünstigen Abscheideverfahren auf billigen Substraten hergestellt werden. Derartige Solarzellen lassen sich großflächig abscheiden, besitzen einen relativ hohen Wirkungsgrad, benötigen im Vergleich zu kristallinen Solarzellen weniger Material, lassen sich integriert zu Modulen verschalten und besitzen neben einer ausgezeichneten Langzeitstabilität auch noch hohe Umweltverträglichkeit.

Polykristalline Dünnschicht-Solarzellen aus Silizium können beispielsweise aus gegossenem und in Blöcken polykristallin erstarrtem Silizium gefertigt werden, wobei die einzelnen Solarzellen aus den großen Blöcken herausgesägt werden müssen. Nachteilig an diesem Verfahren ist der hohe Materialverlust beim Sägen und die für die mechanische Stabilität der gesägten Scheiben erforderliche hohe Dicke der Scheiben. Diese beträgt ein Mehrfaches des für eine vollständige Absorption des Sonnenspektrums erforderlichen Dicke, was neben physikalischen Nachteilen einen weiteren unnötigen Materialverlust zur Folge hat.

Mittels CVD und Plasmaabscheideverfahren können amorphe bis mikrokristalline Schichten direkt auf Substraten in der erforderlichen Dicke abgeschieden werden. Durch aufwendige Rekristallisationsverfahren, beispielsweise durch Laser, können diese amorphen bis mikrokristallinen Schichten in gröberkristalline Schichten überführt werden, die für einen hohen Wirkungsgrad daraus gefertigter polykristalliner Solarzellen erforderlich sind.

Auf kristallinen Substraten lassen sich mittels Epitaxieverfahren kristalline und polykristalline Schichten aufwachsen, die ebenfalls für Solarzellen verwendet werden können. Nachteilig an diesen Verfahren ist jedoch das zumeist teuere Substrat, welches einer wirtschaftlichen und breit angelegten Anwendung dieser Solarzellen im Wege steht.

Für kostengünstige polykristalline Solarzellen sind billige und daher meist amorphe Fremdsubstrate (zum Beispiel Gläser, Keramiken, metallische Bleche und andere) gewünscht. Bei der direkten Abscheidung der Solarzellen auf den Substraten ergibt sich jedoch das Problem, daß die für hocheffiziente grobkristalline Dünnschicht-Solarzellen erforderlichen hohen Abscheidetemperaturen von über 1000°C die Auswahl der Substrate bezüglich ihrer Temperaturbeständigkeit beträchtlich einschränken. Zusätzlich müssen bei diesen hohen Abscheidetemperaturen Diffusions-, Haft- und chemische Reaktionsprobleme berücksichtigt werden.

Aufgabe der vorliegenden Erfindung ist es daher, ein Verfahren zur Herstellung kostengünstiger polykristalliner Dünnschicht-Solarzellen aus Silizium anzugeben, welches die erwähnten Nachteile der bekannten Verfahren vermeidet, auf amorphen Substraten durchführbar ist und zu materialsparenden Dünnschicht-Solarzellen mit hohem Wirkungsgrad führt.

Diese Aufgabe wird erfindungsgemäß gelöst durch ein Verfahren mit den Merkmalen von Anspruch 1.

Weitere Ausgestaltungen der Erfindung sowie eine entsprechend hergestellte Solarzelle sind den Unteransprüchen zu entnehmen.

Mit der Erfindung gelingt es zum ersten Mal, eine definierte und reproduzierbare Keimbildung von Silizium auf billigen und zumindest von der Struktur her frei auswählbaren und daher auch amorphen Substraten durchzuführen. Die Substrate müssen dabei elektrisch leitend oder zumindest elektrisch leitend beschichtet oder mit einer elektrisch leitenden Struktur versehen sein. Vom Material sind solche Substrate geeignet, die die hohen Abscheidetemperaturen von über 1000°C unbeschadet überstehen. Auf solchen Substraten lassen sich mit dem erfindungsgemäßen Verfahren poly-Si-Dünnschichten erzeugen, deren grobkristalline Schichtstruktur Korngrößen von ca. 40 bis 50 µm erreicht.

An das Abscheideverfahren für die polykristalline Siliziumkeimschicht werden keine Anforderungen gestellt, außer daß in der erzeugten Keimschicht Kristallite mit 〈111〉 Orientierung enthalten sein müssen. Anzahl und Größe dieser Kristallite sind unkritisch, da die erforderliche bzw. gewünschte Größe und Dichte dieser Kristallite durch mehrfaches Wiederholen von Abscheidung der Keimschicht und selektiver Rückätzung eingestellt wird.

Für die selektive Rückätzung sind Ätzlösungen und Verfahren bekannt, die bislang insbesondere zur Texturierung von monokristallinen Siliziumoberflächen eingesetzt wurden, da auch dieser Prozeß ein kristallorientiertes (selektives) Ätzen erfordert. Beim erfindungsgemäßen Verfahren verbleiben nach dem Ätzen Keime mit 〈111〉 Orientierung, die die geringste Ätzgeschwindigkeit bzw. die geringste Abtraggeschwindigkeit gegenüber dieser speziellen Ätzung aufweisen. Für das Verfahren ist es ausreichend, wenn die Kristallite nur wenige Nanometer dick sind, da sie bei wiederholtem Erzeugen einer Siliziumkeimschicht bereits als Keime dienen können und dadurch an Größe gewinnen.

Für die Dichte der Keime auf dem Substrat wird ein mittlerer Abstand der Keime gewählt, der zumindest der späteren Schichtdicke der polykristallinen Siliziumdünnschicht entspricht.

Dies garantiert, daß in der Schicht überwiegend senkrecht zum Substrat verlaufende Korngrenzen entstehen, die ebenfalls für eine hocheffiziente Solarzelle unabdingbar erforderlich sind.

Sobald ausreichend viele und große Siliziumkeime auf dem Substrat entstanden sind, werden die Keime zum Aufwachsen einer polykristallinen Schicht verwendet. Dies kann mit üblichen aus der Epitaxie bekannten Verfahren erfolgen, beispielsweise durch Gasphasen oder Flüssigphasenabscheidung aus der Schmelze.

Die 〈111〉 Orientierung der Keime ist aus mehreren Gründen von Vorteil. Eine entsprechend dieser Orientierung gewachsene polykristalline Schicht weist senkrechte Korngrenzen auf und hat eine pyramidenförmige Erhebungen aufweisende aufgerauhte Oberfläche zur Folge. Das Wachstum der Keime erfolgt in 〈111〉 Richtung am langsamsten, in seitlicher Richtung parallel zum Substrat dagegen schneller, so daß beim Aufwachsen der polykristallinen Schicht eine gute und schnelle Flächenbedeckung erreicht wird.

Die Erzeugung des pn-Übergangs und der Vorderseitenkontakte erfolgt nach an sich bekannten Verfahren, beispielsweise durch Phosphordiffusion bzw. durch ein Siebdruckverfahren mit elektrisch leitender Raste.

Bevorzugtes Substratmaterial ist Graphit, das eine hohe thermische und chemische Resistenz besitzt und außerdem den gleichen Ausdehnungskoeffizient wie Silizium aufweist. Es kann in Form von Wafern oder Folien eingesetzt werden und aufgrund seiner elektrischen Leitfähigkeit direkt als Rückseitenkontakt für die späteren Solarzellen dienen. Durch die Siliziumkeimbildung direkt auf dem Graphitsubstrat werden auch die Haftungsprobleme gelöst, die sich aufgrund der Nichtbenetzbarkeit von Graphit durch Silizium ergeben. Bei Verwendung von biegsamen Graphitfolien lassen sich biegsame Solarzellen erzeugen.

Zur Erzeugung der Keimschicht kann ein CVD-Verfahren angewendet werden. Mit einer Abscheiderate von bis zu 5 µm pro Minute wird bei Temperaturen um 1000 bis 1200°C eine gute Benetzung des Graphits mit Silizium erreicht. Als Abscheidegase dienen vorzugsweise Silanwasserstoffgemische, wobei jedoch auch andere siliziumhaltige Gase und Gasgemische geeignet sind, beispielsweise Mischungen mit Chlorsilanen. Unter den genannten Bedingungen werden mit diesem Verfahren bevorzugt Siliziumkristallite mit 〈111〉 Orientierung senkrecht zur Substratoberfläche erhalten. Weitere Variationsmöglichkeiten zur Beeinflussung der Orientierung sind über den Druck gegeben, der im Torrbereich bis hin zu atmosphärischem Druck liegen kann. Zu niedrige Drucke haben eine geringe Wachstumsgeschwindigkeit der Keimschicht zur Folge.

Die selektive Ätzung wird bevorzugt in wäßriger Kaliumhydroxid-Lösung durchgeführt, beispielsweise bei 40°C mit 20 prozentiger Lösung. Dabei stellt sich eine Ätzrate von ca. 0,2 µm pro Minute für die nicht 〈111〉 orientierten Kristallite ein. 〈111〉 orientierte Siliziumkörner bleiben bestehen. Die selektive Ätzrate ist empfindlich von Temperatur und Konzentration der Ätzlösung abhängig.

Abweichend von der naßchemischen Rückätzung kann alternativ ein Plasmarückätzen erfolgen. Dazu wird die Keimschicht vorteilhafterweise nach einem Niedrigdruck CVD-Verfahren (LPCVD) in einem Reaktor erzeugt, der gleichzeitig zum Plasmaätzen verwendet werden kann. Dabei wird mehrmals abwechselnd aus dem Silanwasserstoffgemisch Polysilizium orientiert abgeschieden und danach die Siliziumschicht durch ein CCl₄/O₂-Plasma selektiv geätzt, wobei ebenfalls bevorzugt 〈111〉 orientierte Siliziumkeime entstehen. Bei diesem Verfahren müssen allerdings niedrige Aufwachs- und Ätzraten in Kauf genommen werden.

Die Dichte der Siliziumkeime auf dem Substrat wird durch die Dauer und/oder Intensität der Ätzung eingestellt, wobei eine höhere Ätzdauer eine verringerte Keimdichte zur Folge hat. Vorteilhafterweise wird eine Keimdichte eingestellt, bei der der mittlere Abstand zwischen den Keimen das 1 bis 5-fache der Dicke der späteren polykristallinen Dünnschicht beträgt. Ein optimaler Abstand beträgt beispielsweise 50 µm. Während bei herkömmlichen Solarzellen mit glatter Oberfläche eine Schichtdicke von ca. 100 µm erforderlich ist, um das für Silizium absorbierbare Sonnenlicht nahezu vollständig zu erfassen, ist es beim erfindungsgemäßen Verfahren möglich, die Schichtdicke der Polysiliziumschicht bis auf etwa 10 µm zu reduzieren. Die sich aufgrund der Kristallorientierung von selbst einstellende pyramidenförmige Texturierung der Oberfläche der polykristallinen Dünnschicht bewirkt einen Lichtwellenleitereffekt innerhalb der Dünnschicht. Sowohl das einfallende als auch das reflektierte Sonnenlicht wird innerhalb der Dünnschicht mit Hilfe der Totalreflexion solange geführt, bis es absorbiert ist.

Das Aufwachsen der polykristallinen Schicht erfolgt bevorzugt nach dem LPD-Verfahren (liquid phase deposition), bei dem die mit den Siliziumkeimen versehenen Graphitsubstrate mit einer mit Silizium gesättigten Metallschmelze in Kontakt gebracht werden. Dafür geeignete Metalle sind beispielsweise Zinn, Indium, Antimon, Wismut oder Mischungen aus mehreren dieser Metalle, während die Temperatur für das Verfahren zwischen 600 und 1000°C gewählt wird. Sofern das in der Metallschmelze gelöste Silizium nicht bereits p-dotiert ist, werden ihr zusätzlich geringe Mengen an Bor zugesetzt, die in die aufwachsende Siliziumschicht mit eingebaut werden und diese leicht p-leitend (ca. 1 Ohm/cm) machen. Bei den genannten Bedingungen liegen die Abscheideraten zwischen 0,4 und 4 µm pro Minute, so daß in wenigen Minuten eine gewünschte Schichtdicke erreicht ist. Diese wird zwischen 10 und 50 µm, vorzugsweise zwischen 10 und 30 µm gewählt und ist für hohe Photoströme in der späteren Solarzelle ausreichend. Während des Aufwachsens der polykristallinen Dünnschicht setzt sich die bereits bei den Keimen vorgegebene pyramidenförmige Struktur während des gesamten Wachstums fort und führt so automatisch zu einer Schichtoberfläche der Dünnschicht mit pyramidenförmiger Rauhigkeit. Damit ist die gewünschte Lichtfallengeometrie geschaffen, die durch gewinkelte Mehrfachreflexion einfallender Lichtstrahlen innerhalb der Dünnschicht verlängert und zur Totalabsorption führt.

Die Korngrößen der monokristallinen Bereiche der Dünnschicht erreichen idealerweise den vorgegebenen Abstand der Keime auf dem Substrat und betragen daher bis zu 50 µm. Damit wird die für hocheffiziente Solarzellen erforderliche Diffusionslänge der Minoritätsladungsträger erreicht.

Mit dem erfindungsgemäßen Verfahren können also in kurzer Zeit grobkörnige polykristalline Siliziumdünnschichten auf billigen und leitfähigen Kohlenstoffsubstraten hergestellt werden, die eine weitere Verarbeitung zu hocheffizienten Dünnschicht-Solarzellen erlaubt. Dabei ist sowohl das Abscheideverfahren für die Keimschicht als auch das Aufwachsverfahren für die Siliziumdünnschicht für die Beschichtung großflächiger Substrate geeignet und machen daher eine vergleichsweise preisgünstige Herstellung von Solarzellen möglich.

Die weitere Prozessierung zu einer funktionsfähigen Dünnschicht-Solarzelle erfolgt nach bekannten Schritten. Zunächst wird in der Dünnschicht ein pn-Übergang erzeugt, beispielsweise durch Phosphordiffusion. In einer konventionellen Phosphordiffusionsanlage diffundiert der Phosphor bei etwa 850°C ca. 0,2 bis 0,3 µm tief in die Oberfläche der Dünnschicht ein und erzeugt dort den Übergang.

Alternativ kann auf der bisher erzeugten Dünnschicht eine weitere n-leitende Schicht aus einer zweiten Metallschmelze aufgewachsen werden, die als Dotierelement Phosphor enthält.

Als letzter Schritt erfolgt die Aufbringung eines metallischen Fingerkontakts auf der Vorderseite der Solarzelle, wozu ein herkömmliches Siebdruckverfahren und eine metallische Partikel enthaltende Druckpaste geeignet sind.

Zusätzlich kann über den Vorderseitenkontakten noch eine Antireflexionsschicht aufgebracht werden, um das Sonnenspektrum durch weitere Verhinderung von Reflexionsverlusten noch besser auszunützen bzw. in der Dünnschicht zu absorbieren.

Im folgenden wird die Erfindung anhand von sechs Figuren näher erläutert. Dabei zeigen
- die Figuren 1 bis 5: verschiedene Verfahrensstufen bei der Herstellung einer Dünnschicht-Solarzelle, während
- Figur 6: eine fertige Solarzelle zeigt.

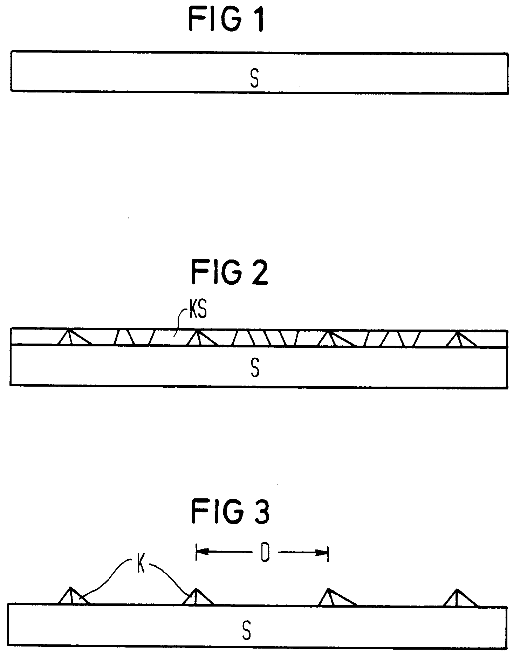

Figur 1: Als Substrat S wird eine leitfähige Graphitfolie oder ein Graphitwafer verwendet. Im ersten Verfahrensschritt a) wird darauf eine polykristalline Siliziumkeimschicht KS erzeugt, die nach einmaliger Abscheidung üblicherweise nanokristallin ist. Neben Kristalliten mit 〈111〉 Orientierung enthält die Keimschicht KS weitere Keimlinge mit beliebiger anderer Orientierung.

Figur 2 zeigt das Substrat S mit der darauf abgeschiedenen Keimschicht, die üblicherweise nur in einer Dicke abgeschieden werden muß, die dem maximalen Durchmesser der Keimlinge entspricht.

Durch selektive Rückätzung, beispielsweise mittels wäßriger KOH-Lösung (zum Beispiel 20 prozentig, 40°C) oder mittels Plasmaätzung (zum Beispiel CCl₄/O₂-Plasma) werden aus der Keimschicht KS sämtliche Kristallite weggeätzt, die nicht 〈111〉 Orientierung aufweisen.

Figur 3 zeigt das Substrat mit den verbliebenen Keimen mit 〈111〉 Orientierung, die zueinander einen mittleren Abstand D aufweisen. Sofern dieser zu gering ist, das heißt weniger als die gewünschte Korngröße in der Dünnschicht beträgt, wird der Ätzprozeß weitergeführt, bis nur noch so viel Keime K übrigbleiben, wie es der gewünschten Keimdichte bzw. dem daraus resultierenden mittleren Abstand von Keim zu Keim entspricht. Optimal ist ein mittlerer Keimabstand D von ca. 50 µm. Durch erneutes Abscheiden einer weiteren Keimschicht KS auf dem bereits mit Keimen K versehenen Substrat S wachsen bevorzugt die bereits vorhandenen Keime K. Nach erneutem selektiven Rückätzen werden vergrößerte Keime K in der gewünschten Dichte erhalten. Aufgrund der 〈111〉 Orientierung besitzen die Keime K eine pyramidenartige Form mit nach oben weisender Spitze.

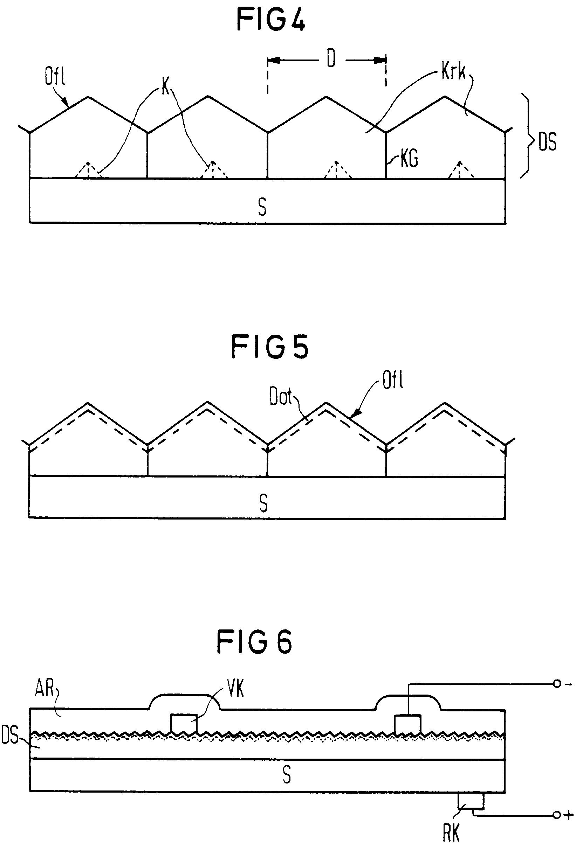

Aus einer mit Silizium gesättigten Metallschmelze (zum Beispiel Zinn/800 bis 1000°C), die mit den Keimen K in Kontakt gebracht wird, läßt man eine polykristalline Dünnschicht DS über den Keimen K aufwachsen. Es entstehen Kristallkörner KrK mit einem mittleren Durchmesser, der dem mittleren Keimabstand D entspricht. Die Korngrenzen KG stehen senkrecht zum Substrat, und stellen für die in der späteren Solarzelle erzeugten Ladungsträger auf dem Weg zu den elektrischen Kontakten keine Rekombinationszentren dar. Die Kristallorientierung der Dünnschicht DS entspricht der 〈111〉 Orientierung der Keime K. Somit erhält die Oberfläche Ofl der Dünnschicht DS ebenfalls eine pyramidenförmige Struktur. Figur 4 zeigt eine so hergestellte Anordnung.

Figur 5: Beispielsweise durch Phosphordiffusion über die Oberfläche Ofl der leicht p-leitenden Dünnschicht DS wird in einem oberflächennahen Bereich eine n-Dotierung Dot und somit ein pn-Übergang erzeugt.

Figur 6: Mittels Siebdruck und einer beispielsweise Silberpartikel enthaltenden Paste werden fingerförmige Elektrodenstrukturen als Vorderseitenkontakte VK auf der Oberfläche Ofl der Dünnschicht DS aufgedruckt. In gleicher Weise kann das bereits leitende Substrat S kontaktiert werden (RK), wozu eine geringere Elektrodendichte gewählt werden kann. Eine wahlweise über den Vorderseitenkontakten VK aufgebrachte Antireflexschicht AR kann die bereits voll funktionsfähige Solarzelle ergänzen.

Mit dem erfindungsgemäßen Verfahren gelingt es erstmals, auf beliebigen amorphen Substraten einheitlich orientierte Keime zu erzeugen. Ebenso ist es daher erstmals möglich, auf beliebigen amorphen Substraten eine einheitlich orientierte polykristalline Dünnschicht aufwachsen zu lassen. Als vorteilhafte Konsequenz ergibt sich daher in einfacher Weise eine pyramidenförmige Oberflächenstruktur der Dünnschicht. In daraus hergestellten Dünnschicht-Solarzellen können daher bereits mit Schichtdicken von 10 bis 30 µm hohe Photoströme erzielt werden, da die Oberflächenstruktur als Lichtfalle wirkt. Die geringe Schichtdicke so erzeugter Dünnschicht-Solarzellen führt daher im Vergleich zu bekannten polykristallinen Dünnschicht-Solarzellen zu einer deutlichen Siliziummaterialeinsparung, die neben dem vereinfachten Verfahrensablauf zu einer Kosteneinsparung führt. Hinzu kommt, daß aufgrund der günstig angeordneten senkrechten Korngrenzen und der einheitlichen Kristallorientierung eine an Rekombinationszentren arme Solarzelle hergestellt werden kann, die auch infolge der physikalisch günstigen geringen Schichtdicke einen hohen Wirkungsgrad besitzt.

## Patentansprüche

1. Verfahren zum Herstellen polykristalliner Solarzellen, bei dem
a) auf einem elektrisch leitenden Substrat (S) eine polykristalline Siliziumkeimschicht (KS) erzeugt wird, welche Siliziumkristallite in 〈111〉 Orientierung enthält,
b) die Keimschicht (KS) selektiv rückgeätzt wird, bis ausschließlich Kristallite mit 〈111〉 Orientierung als Keime (K) auf dem Substrat (S) verbleiben,
c) die Schritte a) und b) gegebenenfalls mehrfach wiederholt werden, bis eine ausreichende Keimdichte und Keimgröße erreicht ist,
d) eine polykristalline Siliziumdünnschicht (DS) entsprechend der Keimorientierung über dem mit den Keimen (K) versehenen Substrat (S) aufgewachsen wird,
e) ein pn-Übergang in der Dünnschicht (DS) erzeugt wird und schließlich
f) auf der Dünnschichtoberfläche (Ofl) Vorderseitenkontakte (VK) aufgebracht werden.

2. Verfahren nach Anspruch 1, bei dem ein Substrat aus Graphit verwendet wird.

3. Verfahren nach Anspruch 1 oder 2, bei dem die Keimschicht (KS) mittels eines CVD-Verfahrens aus Silan erzeugt wird.

4. Verfahren nach einem der Ansprüche 1 bis 3, bei dem mittels wäßriger KOH-Lösung rückgeätzt wird.

5. Verfahren nach einem der Ansprüche 1 bis 4, bei dem die Dünnschicht (DS) in einer Dicke von 10 bis 50 µm, vorzugsweise 10 bis 30 µm erzeugt wird, und der mittlere Keimabstand (D) das 1 bis 5-fache der Schichtdicke beträgt.

6. Verfahren nach einem der Ansprüche 1 bis 5, bei dem die polykristalline Siliziumdünnschicht (DS) nach dem LPD-Verfahren (Liquid Phase Deposition) aus einer mit Silizium gesättigten Metallschmelze auf dem mit den Keimen (K) versehenen Substrat (S) aufgewachsen wird.

7. Verfahren nach einem der vorhergehenden Ansprüche, bei dem die Keimschicht (KS) mit einem LPCVD-Verfahren (low pressure CVD) erzeugt wird und die selektive Rückätzung im selben Reaktor durch Plasmaätzen erfolgt.

8. Polykristalline Dünnschichtsolarzelle mit einem Graphitsubstrat, einer darüber liegenden 10 bis 50 µm dicken polykristallinen Siliziumschicht mit 〈111〉 Orientierung der Kristallite, welche eine mittlere Korngröße von 10 bis 50 µm aufweisen, einer pyramidenförmig ausgebildeten Oberfläche der Siliziumdünnschicht, einem pn-Übergang in der Dünnschicht und einer Fingerelektrodenstruktur als Vorderseitenkontakt auf der Oberfläche der Siliziumdünnschicht.
